# FASCICULE DE BREVET EUROPEEN

(11) **EP 3 540 943 B1**
(45) Date de publication et mention de la délivrance du brevet: **27.08.2025**
(21) Numéro de dépôt: 19161896.6
(22) Date de dépôt: 11.03.2019
(51) Int. Cl.: H03K 3/012

(54) **PROCÉDÉ DE REGULATION D'UNE PUISSANCE D'ALIMENTATION D'UN DISPOSITIF ÉLECTRIQUE**
REGULIERUNGSVERFAHREN DER STROMEINSPEISELEISTUNG EINER ELEKTRISCHEN VORRICHTUNG
METHOD FOR REGULATING A POWER SUPPLY OF AN ELECTRICAL DEVICE

(30) Priorité: 16.03.2018 FR 1852293
(43) Date de publication de la demande: 18.09.2019
(73) Titulaire: Schneider Electric Industries SAS, 92500 Rueil Malmaison (FR)
(72) Inventeur: CORTESE, Gilles, 38050 GRENOBLE Cedex 9 (FR)
(74) Mandataire: Brevalex

(56) Documents cités:
- WO-A1-2013/072793
- US-A1- 2010 270 982
- US-A1- 2014 320 005
- HYE-MAN JUNG ET AL: "A new PWM dimmer using two active switches for AC LED lamp", 2010 INTERNATIONAL POWER ELECTRONICS CONFERENCE : IPEC-SAPPORO 2010 - [ECCE ASIA] ; SAPPORO, JAPAN, IEEE, PISCATAWAY, NJ, USA, 21 June 2010 (2010-06-21), pages 1547 - 1551, XP031729678, ISBN: 978-1-4244-5394-8

## Description

### DOMAINE TECHNIQUE

La présente invention concerne un procédé de régulation d'une puissance d'alimentation d'une charge électrique. En particulier, l'invention concerne un procédé permettant d'ajuster un nombre N d'impulsions de courant alimentant la charge électrique de manière à faire varier la puissance effectivement délivrée audit dispositif.

### ART ANTÉRIEUR

Les procédés de régulation de puissance d'alimentation des charges électriques, connus de l'état de l'art, mettent généralement en œuvre des variateurs de puissance ou gradateurs (« Dimmer » selon la terminologie anglo-saxonne) fonctionnant selon une commande par angle de phase comme décrit par exemple dans le document WO 2013/072793 A1.

Ces gradateurs agissent comme des interrupteurs commandés, qui, pour chaque demi-période du courant alternatif d'alimentation, autorisent le passage dudit courant pendant une durée qui est fonction de la puissance à délivrer à la charge électrique.

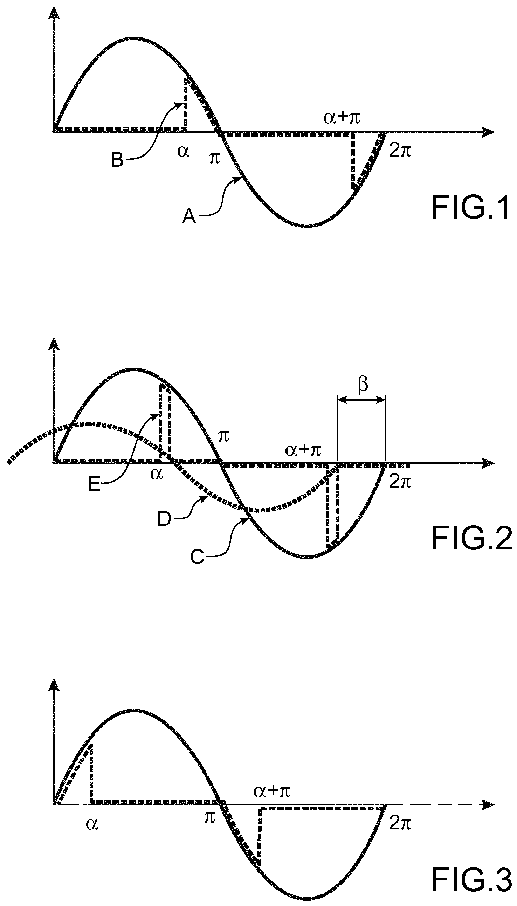

La figure 1 illustre un exemple de commande par angle de phase, dit en « phase descendante » (« Forward Phase Control » selon la terminologie anglo-saxonne). Cette commande en phase descendante est généralement mise en œuvre avec un gradateur pourvu d'un Triac qui devient passant sous l'effet d'un signal de commande et se bloque à chaque alternance du courant le traversant.

Notamment, le signal de commande, pour chaque demi-période d'un courant d'alimentation (courbe A), peut provoquer la commutation du Triac d'un état non-passant vers un état passant avec un angle de retard α de manière à ne laisser passer qu'une fraction (courbe B) du courant d'alimentation dans la charge électrique.

Ce mode de commande est particulièrement adapté pour la régulation de la puissance d'alimentation d'une charge électrique, tel qu'une ampoule à incandescence, se comportant comme une résistance. Dans pareil cas de figure, l'angle de retard α peut prendre n'importe quelle valeur entre 0° et 180°, et notamment permettre une extinction quasi complète d'une ampoule à incandescence pour des valeurs d'angles de retard α proches de 180°.

Cependant, ce mode de commande n'est pas satisfaisant dès lors que la charge électrique est de faible puissance et n'est pas équivalente à une résistance, comme par exemple une ampoule LED ou Fluorescente.

En effet, tel qu'illustré à la figure 2, un déphasage β, entre la tension (courbe C) aux bornes d'une lampe LED ou fluorescente et le courant (courbe D) la traversant, peut être observé, limitant de facto la plage d'angles de retard admissible à la gamme d'angles comprise entre 0° et (180° - β).

Ainsi, dès lors qu'une faible illumination est requise, la lampe LED ou fluorescente n'est plus alimentée que par une impulsion fine (courbe E) à chaque demi période du courant d'alimentation (l'angle de retard α=αₘₐₓ est proche de 180°-β) qui provoquent un clignotement et/ou un bourdonnement de ladite lampe.

Afin de pallier ce problème, il a pu être proposé un autre mode de commande par angle de phase dit en « phase montante » (« Reverse Phase Control » selon la terminologie anglo-saxonne).

Un tel mode est généralement mis en œuvre avec un gradateur pourvu d'un transistor de type MOS qui commande le passage d'un état bloqué vers un état passant dès le passage par zéro du courant d'alimentation et selon une durée d'angle α (figure 3).

Cependant, ce mode de commande n'est pas non plus satisfaisant.

En effet, la commande du transistor de type MOS nécessite un courant important pour fonctionner par rapport à la consommation d'une ampoule LED ou fluorescente qui peut perturber le fonctionnement de cette dernière, et le cas échéant empêcher son extinction quasi complète même pour un retard d'angle αfaible.

De manière alternative, il a également été considéré une régulation de la puissance d'alimentation d'une ampoule LED ou fluorescente par une commande de « Modulation par Largeur d'Impulsion » (« PWM » ou « Pulse Width Modulation » selon la terminologie anglo-saxonne).

Cependant, cette alternative ne permet pas d'imposer un éclairement nul de l'ampoule LED ou fluorescente et n'est donc pas satisfaisante.

Les documents WO 2013/072793, US 2010/270982, et US 2014/320005 divulguent des dispositifs de gradation dont le fonctionnement ne permet pas de résoudre les problèmes susmentionnés.

Un but de la présente invention est donc de proposer un procédé de régulation de la puissance d'alimentation d'une charge électrique qui peut présenter un comportement autre que celui d'une résistance.

Un autre but de la présente invention est également de proposer un procédé de régulation de la puissance d'alimentation d'une charge électrique de faible puissance, notamment une puissance inférieure à quelques Watts, par exemple inférieure à 10 Watts.

Un autre but de la présente invention est de proposer un procédé de régulation de la puissance d'alimentation d'une charge électrique permettant une extinction quasi complète, voire complète, dudit dispositif.

Un autre but de la présente invention est de proposer un procédé de régulation de la puissance d'alimentation d'une charge électrique mettant en œuvre un gradateur faiblement consommateur, voire non consommateur, de puissance.

### EXPOSÉ DE L'INVENTION

L'invention est définie par les revendications indépendantes et s'adresse à un procédé de régulation d'une puissance d'une charge électrique alimenté par une source de courant alternatif de période T, la charge étant connectée en série avec un gradateur de puissance générant, pour chaque demi période T/2 du courant alternatif, un nombre N d'impulsions de courant destinées à alimenter ladite charge, le procédé comprenant l'ajustement du nombre N en fonction de la puissance à délivrer à la charge électrique.

Selon un mode de mise en œuvre, dès lors que la puissance à délivrer à la charge électrique est nulle, le nombre N d'impulsions de courant est également nul pour chaque demi-période T/2 du courant alternatif.

Selon un mode de mise en œuvre, la durée de chaque impulsion de courant est inférieure à 5 millièmes de la période T, avantageusement comprise entre 25 dix millièmes et 5 millièmes de la période T.

Selon un mode de mise en œuvre, les N impulsions de courant, pour chaque demi période T/2, présentent une durée sensiblement égale.

Selon un mode de mise en œuvre, pour chaque demi période T/2, les N impulsions sont centrées par rapport à ladite demi période T/2 et, avantageusement équidistantes les unes des autres.

Selon un mode de mise en œuvre, la charge électrique comprend soit système de chauffage électrique, soit un moteur électrique, soit une ampoule LED ou fluorescente, notamment d'une puissance inférieure à 10 Watt.

Par « lampe fluorescente », on entend également une lampe fluorescente compacte (LFC) ou plus simplement lampe fluo-compacte. Une lampe fluorescente peut, au sens de la présente invention, être une lampe basse consommation, et en particulier présenter une puissance inférieure à 10 watt.

Selon l'invention, le gradateur de puissance comprend :
- un générateur d'impulsions pourvu de deux bornes primaires dites, respectivement, première borne primaire et seconde borne primaire formant les bornes du gradateur de puissance, et de deux bornes secondaires, dites, respectivement, première borne secondaire et seconde borne secondaire;
- un premier transistor Darlington de type NPN, connecté à la première borne secondaire par sa base et à la première borne primaire par son émetteur ;
- un second transistor Darlington de type PNP, connecté à la seconde borne secondaire par sa base et à la première borne primaire par son émetteur.

Selon l'invention, le générateur GI comprend entre la première borne primaire et la seconde borne primaire, et dans l'ordre, un premier condensateur et un potentiomètre, le générateur comprend également un DIAC de tension d'amorçage Va connecté selon une de ses bornes, dite borne de commande, à un premier nœud commun au premier condensateur et au potentiomètre, un second condensateur et un troisième condensateur sont interposés entre l'autre borne du DIAC, dite borne de sortie, et, respectivement, la première borne secondaire et la seconde borne secondaire.

Selon un mode de mise en œuvre, le générateur est pourvu d'une seconde résistance et d'une troisième résistance reliant chacune la première borne primaire à la borne de sortie.

Selon un mode de mise en œuvre, le générateur comprend une première diode et une seconde diode interposées entre la première borne primaire et, respectivement, la première borne secondaire et la seconde borne secondaire.

Selon un mode de mise en œuvre, le gradateur de puissance comprend un étage d'aide à la commutation connecté au collecteur du premier transistor Darlington par une première borne d'entrée et au collecteur du second transistor Darlington par une seconde borne d'entrée, l'étage d'aide à la commutation comprend également deux bornes de sortie dites, respectivement, première borne de sortie et second borne de sortie toutes deux connectées à la seconde borne primaire.

Selon un mode de mise en œuvre, l'étage d'aide à la commutation comprend d'une part, entre sa première borne d'entrée et sa première borne de sortie, une troisième et une quatrième diodes montées en série selon des polarités opposées et d'autre part, entre sa seconde borne d'entrée et sa seconde borne de sortie, une cinquième et une sixième diodes également montées en série selon des polarités opposées.

Selon un mode de mise en œuvre, la borne commune des troisième et quatrième diodes est reliée à la première borne de sortie par une première branche comprenant, en série, une première inductance et une quatrième résistance, et la borne commune des cinquième et sixième diodes est reliée à la seconde borne de sortie par une seconde branche comprenant, en série, une seconde inductance et une cinquième résistance.

Selon un mode de mise en œuvre, les bornes communes des troisième et quatrième diodes d'une part, et des cinquième et sixième diodes d'autre part sont reliées par une inductance.

Selon un mode de mise en œuvre, le procédé comprend la mise en œuvre d'un filtre qui comprend deux bornes d'entrée et connectées, respectivement, à la première borne primaire et à la seconde borne primaire, et deux bornes de sortie et connectées en série avec la charge électrique.

Selon un mode de mise en œuvre, le filtre est pourvu de deux inductances et d'une quatrième capacité C4, les deux inductances, reliant, respectivement, l'entrée X2 à la sortie Y2, et l'entrée X1 à la sortie Y1, tandis que la quatrième capacité relie les sorties Y1 et Y2.

### BRÈVE DESCRIPTION DES DESSINS

D'autres caractéristiques et avantages apparaîtront dans la description qui va suivre d'un procédé de régulation d'une puissance d'une charge électrique selon l'invention, donnés à titre d'exemples non limitatifs, en référence aux dessins annexés dans lesquels :
- la figure 1 est une représentation graphique d'une commande selon un retard d'angle α en phase descendante mise en œuvre avec une ampoule à incandescence, connue de l'état de la technique ;
- la figure 2 est une représentation graphique d'une commande selon un retard d'angle α en phase descendante mise en œuvre avec une ampoule LED ou fluorescente, connue de l'état de la technique ;
- la figure 3 est une représentation graphique d'une commande selon un retard d'angle α en phase montante mise en œuvre avec une ampoule à incandescence, connue de l'état de la technique ;
- les figures 4a à 4d sont des représentations graphiques d'une tension d'alimentation alternative (courbe F, tension représentée par l'axe vertical) en fonction du temps (axe horizontal), sur chacune de ces figures sont également représentées des impulsions de courants Ci (symbolisées par des bâtons verticaux) dont le nombre est ajusté en fonction d'une puissance à délivrer à la charge électrique selon la présente invention ;
- la figure 5 est une représentation schématique de l'alimentation de la charge électrique susceptible d'être mise en œuvre pour l'exécution du procédé selon la présente invention ;
- les figures 6a et 6b sont des représentations schématiques, respectivement, d'une première variante (figure 6a) et d'une seconde variante (figure 6b) d'un gradateur de puissance convenant à la mise en œuvre du procédé selon la présente invention ;
- les figures 7a à 7c sont des représentations graphiques de la mise en œuvre du gradateur de puissance de la figure 6a avec une ampoule LED, en particulier, sur chacune de ces figures, la courbe du haut représente l'évolution temporelle de la tension aux bornes de la première capacité C1 tandis que la courbe du bas la mise en conduction des transistors Darlington TD1 et TD2.

### EXPOSÉ DÉTAILLÉ DE MODES DE RÉALISATION PARTICULIERS

La présente invention propose un procédé de régulation de la puissance d'une charge électrique, et notamment une ampoule LED ou fluorescente ou encore une ampoule à incandescence de faible puissance (inférieure à 10 Watt).

Le procédé selon la présente invention propose de réguler la puissance effectivement transmise à la charge électrique en contrôlant un nombre N d'impulsions de courant traversant ladite charge. Le procédé selon la présente invention permet ainsi de réguler le fonctionnement de la charge électrique, et dans le cas d'ampoules LEDs ou fluorescentes, de parvenir à leur extinction totale.

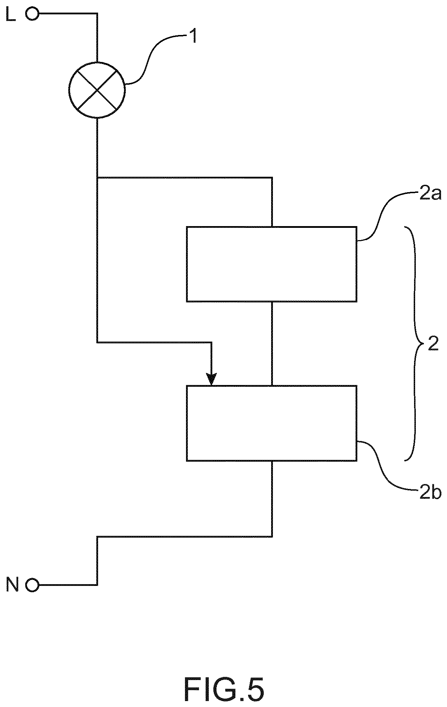

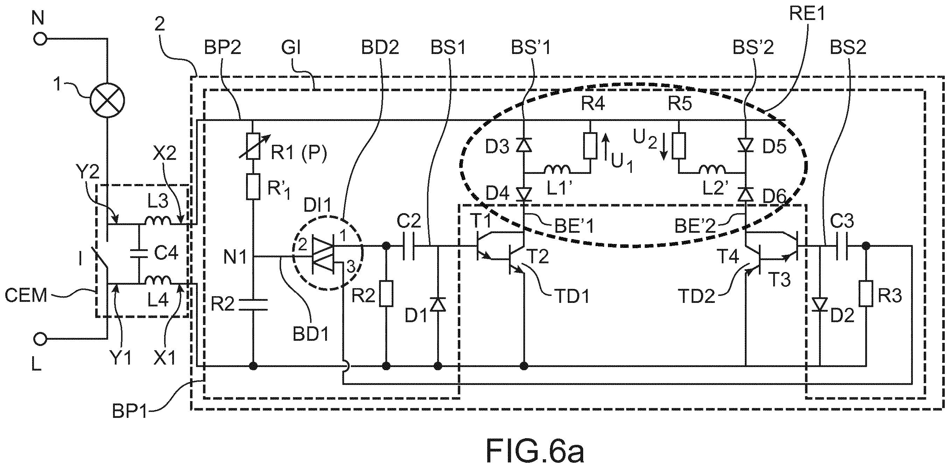

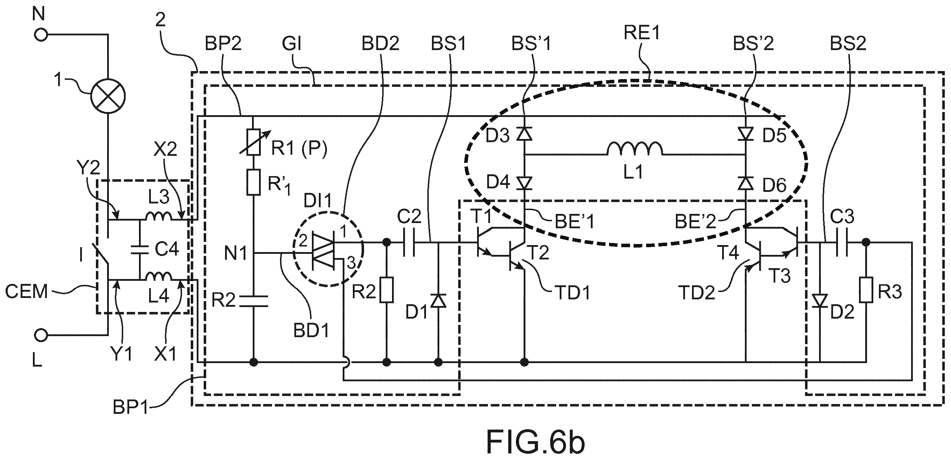

Aux figures 5, 6a et 6b, on peut voir une charge électrique1 connectée en série avec un gradateur de puissance 2 convenant à la mise en œuvre du procédé selon la présente invention. L'ensemble formé par le dispositif 1 et le gradateur de puissance 2 est alimenté, via une source (symbolisée par « L » et « N »), par un courant alternatif de période T.

Le gradateur de puissance 2, au sens de la présente invention, peut être un commutateur électronique, par exemple commandé, autorisant ou non l'alimentation en courant de la charge électrique 1. Le commutateur électronique peut comprendre un transistor, par exemple un transistor MOS, un transistor bipolaire, un IGBT (« Transistor Bipolaire à Grille Isolée »), un thyristor.

En particulier, le gradateur de puissance 2 peut être passant selon des lapses de temps, dits temps d'impulsion Ti, de manière à alimenter en courant la charge électrique1, et non passant le reste du temps.

En d'autres termes, le gradateur de puissance 2, pendant un temps d'impulsion Ti, permet la génération d'une impulsion de courant Ci destinée à circuler dans la charge électrique1.

Le procédé de régulation de puissance de la charge électrique 1 comprend donc, pour chaque demi-période T/2 du courant alternatif, la génération d'un nombre N d'impulsions de courant Ci destinées à alimenter la charge électrique 1. Il est entendu que chaque impulsion de courant Ci présente une durée égale au temps d'impulsion Ti.

Le temps d'impulsion Ti est avantageusement inférieur à 5 millièmes de la période T, encore plus avantageusement le temps d'impulsion Ti est compris entre 25 dix millièmes et 5 millièmes de la période T.

En d'autres termes, pour une fréquence du courant de 50 Hz, le temps d'impulsion Ti est avantageusement inférieur à 10 µs (µs = micro seconde), encore plus avantageusement compris entre 2,5 µs et 10 µs.

De manière particulièrement avantageuse, le procédé selon la présente invention comprend l'ajustement du nombre N en fonction de la puissance à délivrer à la charge électrique 1.

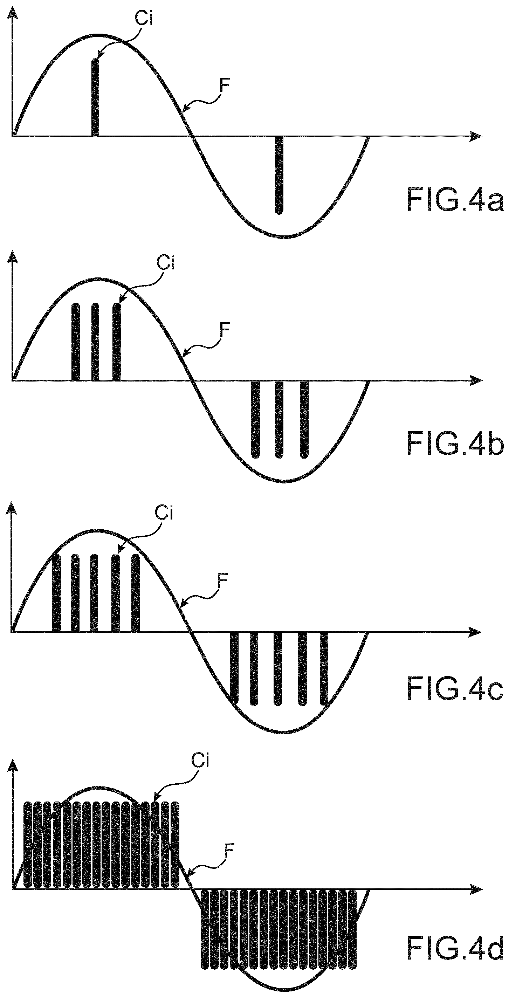

A titre d'exemple les figures 4a à 4d illustrent la mise en œuvre du procédé selon l'invention. En particulier, les figures 4a et 4d sont des représentations graphiques de la tension d'alimentation fournie par la source (courbe F) en fonction du temps, superposée avec les impulsions de courant Ci. Le nombre N d'impulsions de courant va croissant de la figure 4a à la figure 4d, et permet ainsi d'augmenter la puissance alimentant effectivement la charge électrique 1.

Le procédé selon la présente invention permet avantageusement d'utiliser l'intégralité de chacune des demi périodes du courant d'alimentation. En d'autres termes, tous les angles de déphasage sont atteignables (même en cas de déphasage important entre la tension et le courant aux bornes de la charge électrique).

La commande d'alimentation de la charge électrique est également linéaire.

Le procédé selon la présente invention est donc avantageusement mis en œuvre pour faire varier l'intensité lumineuse d'une ampoule, notamment une ampoule LED ou fluorescente de faible puissance (par exemple inférieure à 10 Watts). Il permet, en particulier, d'envisager une extinction quasi complète de ces ampoules en ajustant le nombre N d'impulsions à une faible valeur, par exemple N = 1. Une valeur d'impulsion N = 0 permet une extinction complète de l'ampoule.

La figure 5 représente, de manière schématique, le principe d'alimentation de la charge électrique par un gradateur 2. Selon ce principe, le gradateur 2 et la charge électrique 1 sont connectés en série. Par ailleurs, le gradateur comprend une alimentation 2a et une commande 2b. Cette disposition permet d'obtenir une extinction quasi complète, voire complète, dudit dispositif puisque le courant circulant dans l'alimentation 2a circule également dans la commande 2b.

Le procédé selon la présente invention peut être mis en œuvre par le gradateur de puissance 2 représenté aux figures 6a et 6b.

Le gradateur de puissance 2 comprend notamment :
- un générateur GI d'impulsions pourvu de deux bornes primaires dites, respectivement, première borne primaire BP1 et seconde borne primaire BP2 formant les bornes du gradateur de puissance, et deux bornes secondaires, dites, respectivement, première borne secondaire BS1 et seconde borne secondaire BS2 ;
- un premier transistor Darlington TD1, par exemple de type NPN, connecté à la première borne secondaire BS1 par sa base et à la première borne primaire BP1 par son émetteur ;
- un second transistor Darlington TD2, par exemple de type PNP, connecté à la seconde borne secondaire BS2 par sa base et à la première borne primaire BP1 par son émetteur.

Par « transistor Darlington », on entend un montage de deux transistors bipolaires, éventuellement de même type, dits, respectivement, transistor de commande et transistor de sortie. Dans ce montage, les collecteurs sont communs et correspondent au collecteur du Darlington, l'émetteur du transistor de commande est relié à la base du transistor de sortie, la base du transistor de commande et l'émetteur du transistor de sortie correspondent respectivement à la base et à l'émetteur du Darlington.

Le générateur GI comprend entre la première borne primaire BP1 et la seconde borne primaire BP2, et dans l'ordre, un premier condensateur C1 et un potentiomètre R1 de résistance variable. En d'autres termes, le premier condensateur C1 et le potentiomètre R1 sont connectés en série selon un premier nœud N1 commun.

Le générateur GI comprend également un DIAC DI1 (« Diode for Alternating Current » selon la terminologie anglo-saxonne) de tension d'amorçage Va connecté selon une de ses bornes, dite borne de commande BD1, au premier nœud N1.

Par « DIAC », on entend deux triples jonction PNPN montées tête-bêche.

Un second condensateur C2 et un troisième condensateur C3 sont interposés entre l'autre borne du DIAC DI1, dite borne de sortie BD2, et, respectivement, la première borne secondaire BS1 et la seconde borne secondaire BS2. Le second condensateur C2 et le troisième condensateur C3 permettent de fixer la durée d'impulsion de commande, respectivement, du premier transistor Darlington TD1 et du second transistor Darlington TD2.

En fonctionnement, et considérant une alternance positive de la tension délivrée par la source, une tension Ve appliquée entre la première borne primaire BP1 et la seconde borne primaire BP2, provoque une phase de charge et de décharge du premier condensateur C1 qui est fonction de la résistance du potentiomètre R1.

Lors de la charge du premier condensateur C1, la tension au premier nœud augmente jusqu'à atteindre la tension d'amorçage Va. Le DIAC DI1 se met alors en conduction, permettant ainsi au premier condensateur C1 de se décharger, via le DIAC DI1, dans le second condensateur C2 puis dans le premier transistor Darlington TD1 sous forme d'une impulsion de courant venant alimenter la charge électrique 1. Plus précisément, le second condensateur C2 fixe la durée de l'impulsion de commande du premier transistor Darlington TD1.

La décharge du premier condensateur C1, qui ne dure qu'un très court lapse de temps correspondant au temps d'impulsion Ti, s'accompagne d'une diminution de la tension au niveau du premier nœud N1, et provoque ainsi le blocage du DIAC DI1.

Ce phénomène de charge et de décharge du premier condensateur C1 peut se produire plusieurs fois au cours d'une même alternance de la tension dépendamment de la résistance électrique imposée par le potentiomètre R1. En d'autres termes, il est possible d'ajuster le nombre N d'impulsions en ajustant la résistance électrique du potentiomètre R1.

Le même raisonnement s'applique pour une alternance négative de la tension imposée par la source. Dans ce cas de figure, la décharge du premier condensateur C1 s'effectue dans le troisième condensateur C3 puis dans le second transistor Darlington TD2. Plus précisément, le second condensateur C3 fixe la durée de l'impulsion de commande du second transistor Darlington TD2.

Le gradateur de puissance 2, présenté aux figures 6a et 6b, peut présenter d'autres composants. Notamment, il peut être pourvu d'une seconde résistance R2 et d'une troisième résistance R3 reliant chacune la première borne primaire BP1 à la borne de sortie BD2 du DIAC DI1.

Une première diode D1 et une seconde diode D2 peuvent également s'interposer entre la première borne primaire BP1 et, respectivement, la première borne secondaire BS1 et la seconde borne secondaire BS2.

Enfin le gradateur de puissance 2 peut comprendre un étage d'aide à la commutation RE1 connecté au collecteur du premier transistor Darlington TD1 par une première borne d'entrée BE'1 et au collecteur du second transistor Darlington TD2 par une seconde borne d'entrée BE'2.

L'étage d'aide à la commutation RE1 comprend également deux bornes de sortie dites, respectivement, première borne de sortie BS'1 et second borne de sortie BS'2 toutes deux connectées à la seconde borne primaire BP2.

L'étage d'aide à la commutation RE1 peut comprendre d'une part, entre sa première borne d'entrée BE'1 et sa première borne de sortie BS'1, une troisième diode D3 et une quatrième diode D4 montées selon des polarités opposées et d'autre part, entre sa seconde borne d'entrée BE'2 et sa seconde borne de sortie BS'2, une cinquième diode D5 et une sixième diode D6 également montées selon des polarités opposées. La première diode D3 et la cinquième diode D5 sont des diodes dite « de roue libre » permettant de faire circuler le courant stocké dans au moins une inductance lorsque les transistors TD1 et TD2 sont ouverts ou non conducteurs.

Selon une première variante représentée à la figure 6a, la borne commune des troisième et quatrième diodes D3 et D4 peut être reliée à la première borne de sortie BS'1 par une première branche comprenant, en série, une première inductance L1' et une quatrième résistance R4 (R4 symbolise une charge électrique de commande susceptible de fournir une alimentation électrique). De manière équivalente, la borne commune des cinquième et sixième diodes D5 et D6 peut être reliée à la seconde borne de sortie BS'2 par une seconde branche comprenant, en série, une seconde inductance L2' et une cinquième résistance R5 (R5 symbolise une charge électrique de commande susceptible de fournir une alimentation électrique).

En fonctionnement, les tensions U1 et U2 générées aux bornes des quatrième R4 et cinquième R5 résistance, pendant les phases de charge/décharge du second condensateur C2, peuvent être utilisées pour alimenter une électronique, par exemple une interface Homme-machine. Ce fonctionnement est un fonctionnement de type « hacheur ». Les premières et secondes inductances L1 et L2 sont des inductances de stockage de l'énergie pendant la phase de conduction des transistors TD1 et TD2 et de restitution de l'énergie aux charges R4 et R5 pendant la phase de « roue libre » via les diodes de « roue libre » D3 et D5 .

Si ces deux tensions U1 et U2 ne sont pas utilisées, l'énergie qui leur est associée peut être réinjectée au niveau de la seconde borne primaire BP2.

Selon une seconde variante représentée à la figure 6b, les bornes communes des troisième et quatrième diodes D3 et D4 d'une part, et des cinquième et sixième diodes D5 et D6 d'autre part sont reliées par une inductance L1.

En fonctionnement, par exemple lors d'une alternance positive de la tension source, lorsque le premier transistor Darlington TD1 conduit, l'inductance L1 se charge à travers les quatrième et cinquième diodes D4, D5 ainsi que le premier transistor Darlington TD1. Dès lors que la conduction dans le premier transistor Darlington s'arrête, le courant stocké dans l'inductance L1 circule en roue libre dans les troisième et cinquième diodes D3 et D5 .

Lors d'une alternance négative de la tension source, l'inductance L1 se charge à travers les troisième et sixième diodes D3, D6ainsi que le second transistor Darlington TD2.Dès lors que la conduction dans le second transistor Darlington TD2 s'arrête, le courant stocké dans l'inductance L1 circule en roue libre dans les troisième et cinquième diodes D3 et D5. La première diode D3 et la cinquième diode D5 sont des diodes dite « de roue libre » permettant de faire circuler le courant stocké dans l'inductance L1 lorsque les transistors TD1 et TD2 sont ouverts ou non conducteurs

Quelle que soit la variante considérée, l'étage d'aide à la commutation , lors de la mise en conduction de l'un ou l'autre des premier et second transistor Darlington, permet de réguler le courant dans lesdits transistors Darlington. En particulier, l'étage d'aide à la commutation (notamment la ou les inductances), lors de la mise en conduction d'un transistor de Darlington, permet de limiter l'établissement du courant et ainsi réduire les pertes à la commutation. Cette limitation à l'établissement du courant est par ailleurs moins « polluante » d'un point de vue électromagnétique, et notamment de limiter l'établissement du courant

Un filtre CEM peut également être considéré pour supprimer des perturbations susceptibles d'être injectées sur le réseau.

Le filtre CEM s'interpose entre le gradateur de puissance 2 et la source. En particulier, le filtre CEM comprend deux bornes d'entrée X1 et X2 connectées, respectivement, à la première borne primaire BP1 et à la seconde borne primaire BP2, et deux bornes de sortie Y1 et Y2 connectées en série avec la charge électrique 1.

Le filtre CEM peut être pourvu de deux inductances L3 et L4 et d'une quatrième capacité C4. En particulier les deux inductances L3 et L4, relient, respectivement, l'entrée X2 à la sortie Y2, et l'entrée X1 à la sortie Y1, tandis que la quatrième capacité relie les sorties Y1 et Y2.

Le gradateur de puissance 2 représenté à la figure 6a a été mis en œuvre pour la régulation de la puissance d'une ampoule LED.

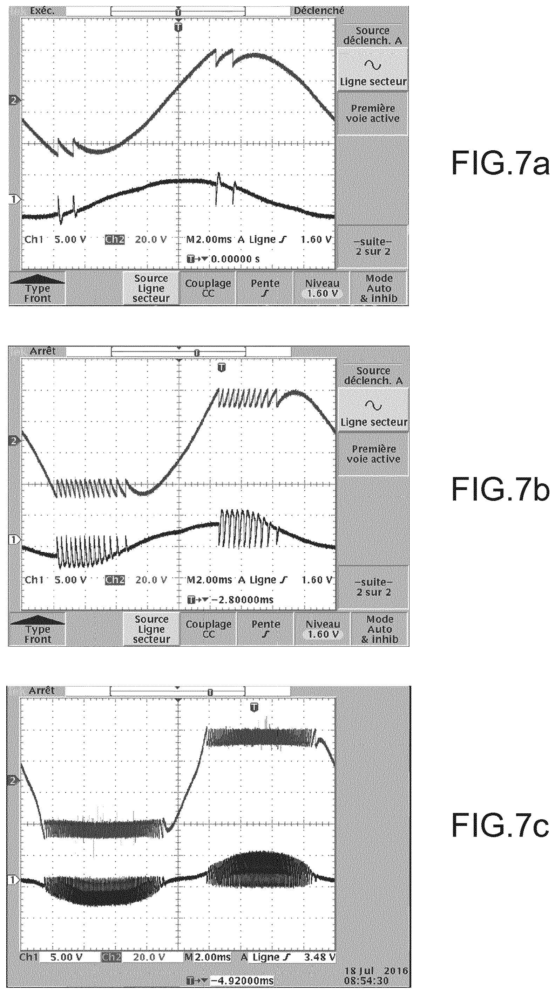

Les figures 7a à 7c sont des représentations graphiques de cette régulation. En particulier, sur chacune de ces figures, la courbe du haut représente l'évolution temporelle de la tension aux bornes de la première capacité C1 tandis que la courbe du bas la mise en conduction des transistors Darlington TD1 et TD2.

Sur ces figures des charges et décharges du premier condensateur C1 apparaissent (repérées par les chutes brutales de tension). Leur nombre (nombre N) est fonction de la résistance R1 du potentiomètre. Plus précisément, plus R1 est faible plus le nombre N est élevé. Ces chutes brutales de tension s'accompagnent d'une mise en conduction de l'un ou l'autre du transistor Darlington, dépendamment de l'alternance positive ou négative de la tension source.

Ainsi, l'ajustement du potentiomètre R1 à une valeur de résistance élevée procure un faible éclairage de l'ampoule LED (figure 7a). En revanche, une valeur de résistance R1 élevée, impose à l'ampoule LED un grand nombre d'impulsions de courant, de sorte que cette dernière procure un fort éclairage (figure 7c). La figure 7b illustre une situation intermédiaire pour laquelle l'éclairage fourni par l'ampoule LED est d'intensité moyenne.

Le procédé selon la présente invention permet donc de réguler la puissance d'alimentation d'une charge électrique, et notamment d'une ampoule présentant un comportement autre que celui d'une résistance.

Par ailleurs, ce même procédé permet également de considérer une extinction quasi complète, voire complète, d'une charge électrique de faible puissance, et notamment d'une puissance inférieure à quelques Watts, par exemple inférieure à 10 Watts.

Enfin le gradateur de puissance représenté aux figures 6a et 6b permettant de mettre en œuvre le procédé selon la présente invention consomme peu ou pas de puissance.

## Revendications

1. Procédé de régulation d'une puissance d'une charge électrique (1) alimenté par une source de courant alternatif de période T, la charge étant connectée en série avec un gradateur de puissance (2) générant, pour chaque demi période T/2 du courant alternatif, un nombre N d'impulsions de courant destinées à alimenter ladite charge, le procédé comprenant l'ajustement du nombre N en fonction de la puissance à délivrer à la charge électrique (1).

2. Procédé selon la revendication 1, dans lequel dès lors que la puissance à délivrer à la charge électrique (1) est nulle, le nombre N d'impulsions de courant est également nul pour chaque demi-période T/2 du courant alternatif.

3. Procédé selon la revendication 1 ou 2, dans lequel la durée de chaque impulsion de courant est inférieure à 5 millièmes de la période T, avantageusement comprise entre 25 dix millièmes et 5 millièmes de la période T.

4. Procédé selon L'une des revendications 1 à 3, dans lequel les N impulsions de courant, pour chaque demi période T/2, présentent une durée sensiblement égale.

5. Procédé selon l'une des revendications 1 à 4, dans lequel, pour chaque demi période T/2, les N impulsions sont centrées par rapport à ladite demi période T/2 et, avantageusement équidistantes les unes des autres.

6. Procédé selon l'une des revendications 1 à 5, dans lequel la charge électrique (1) comprend soit système de chauffage électrique, soit un moteur électrique, soit une ampoule LED ou fluorescente, notamment d'une puissance inférieure à 10 Watt.

7. Procédé selon l'une des revendications 1 à 6 dans lequel le gradateur de puissance (2) comprend :
- un générateur (GI) d'impulsions pourvu de deux bornes primaires dites, respectivement, première borne primaire (BP1) et seconde borne primaire (BP2) formant les bornes du gradateur de puissance (2), et de deux bornes secondaires, dites, respectivement, première borne secondaire (BS1) et seconde borne secondaire (BS2) ;
- un premier transistor Darlington (TD1) de type NPN, connecté à la première borne secondaire (BS1) par sa base et à la première borne primaire (BP1) par son émetteur ;
- un second transistor Darlington (TD2) de type PNP, connecté à la seconde borne secondaire (BS2) par sa base et à la première borne primaire (BP1) par son émetteur.

8. Gradateur de puissance (2) qui lorsqu'il est connectée en série entre une charge électrique (1) et une source de courant alternatif de période T, est destiné, pour chaque demi période de courant T/2 du courant alternatif, à générer un nombre N d'impulsions de courant destinées à alimenter ladite charge, le gradateur comprenant comprend :
- un générateur (GI) d'impulsions pourvu de deux bornes primaires dites, respectivement, première borne primaire (BP1) et seconde borne primaire (BP2) formant les bornes du gradateur de puissance (2), et de deux bornes secondaires, dites, respectivement, première borne secondaire (BS1) et seconde borne secondaire (BS2), ledit générateur (GI) comprenant entre la première borne primaire (BP1) et la seconde borne primaire (BP2), et dans l'ordre, un premier condensateur (C1) et un potentiomètre (R1), le générateur (GI) comprend également un DIAC (DI1) de tension d'amorçage Va connecté selon une de ses bornes, dite borne de commande (BD1), à un premier nœud (N1) commun au premier condensateur (C1) et au potentiomètre (R1) permettant d'ajuster le nombre N, un second condensateur (C2) et un troisième condensateur (C3) sont interposés entre l'autre borne du DIAC DI1, dite borne de sortie (BD2), et, respectivement, la première borne secondaire (BS1) et la seconde borne secondaire (BS2) ;
- un premier transistor Darlington (TD1) de type NPN, connecté à la première borne secondaire (BS1) par sa base et à la première borne primaire (BP1) par son émetteur;
- un second transistor Darlington (TD2) de type PNP, connecté à la seconde borne secondaire (BS2) par sa base et à la première borne primaire (BP1) par son émetteur.

9. Gradateur selon la revendication 8, dans lequel le générateur (GI) est pourvu d'une seconde résistance (R2) et d'une troisième résistance (R3) reliant chacune la première borne primaire (BP1) à la borne de sortie (BD2).

10. gradateur selon la revendication 8 ou 9, dans lequel le générateur (GI) comprend une première diode (D1) et une seconde diode (D2) interposées entre la première borne primaire (BP1) et, respectivement, la première borne secondaire (BS1) et la seconde borne secondaire (BS2).

11. Gradateur selon l'une des revendications 8 à 10, dans lequel le gradateur de puissance (2) comprend un étage d'aide à la commutation (RE1) connecté au collecteur du premier transistor Darlington (TD1) par une première borne d'entrée (BE'1) et au collecteur du second transistor Darlington (TD2) par une seconde borne d'entrée (BE'2), l'étage d'aide à la commutation (RE1) comprend également deux bornes de sortie dites, respectivement, première borne de sortie (BS'1) et second borne de sortie (BS'2) toutes deux connectées à la seconde borne primaire (BP'2).

12. Gradateur selon la revendication 11, dans lequel l'étage d'aide à la commutation (RE1) comprend d'une part, entre sa première borne d'entrée (BE'1) et sa première borne de sortie (BS'1), une troisième et une quatrième diodes (D3) et (D4) montées en série selon des polarités opposées et d'autre part, entre sa seconde borne d'entrée (BE'2) et sa seconde borne de sortie (BS'2), une cinquième et une sixième diodes (D5 ) et (D6) également montées en série selon des polarités opposées.

13. Gradateur selon la revendication 12, dans lequel la borne commune des troisième et quatrième diodes (D3) et (D4) est reliée à la première borne de sortie (BS'1) par une première branche comprenant, en série, une première inductance (L1') et une quatrième résistance (R4), et la borne commune des cinquième et sixième diodes (D5 ) et (D6) est reliée à la seconde borne de sortie (BS'2) par une seconde branche comprenant, en série, une seconde inductance (L2') et une cinquième résistance (R5).

14. Gradateur selon la revendication 12, dans lequel les bornes communes des troisième et quatrième diodes (D3) et (D4) d'une part, et des cinquième et sixième diodes (D5 ) et (D6) d'autre part sont reliées par une inductance (L1).

15. Gradateur selon l'une des revendications 8 à 14, dans lequel le procédé comprend la mise en œuvre d'un filtre (CEM) qui comprend deux bornes d'entrée (X1) et (X2) connectées, respectivement, à la première borne primaire (BP1) et à la seconde borne primaire (BP2), et deux bornes de sortie (Y1) et (Y2) connectées en série avec la charge électrique (1).

16. Gradateur selon la revendication 15, dans lequel le filtre (CEM) est pourvu de deux inductances (L3) et (L4) et d'une quatrième capacité (C4), les deux inductances (L3) et (L4), reliant, respectivement, l'entrée (X2) à la sortie (Y2), et l'entrée (X1) à la sortie (Y1), tandis que la quatrième capacité (C4) relie les sorties (Y1) et (Y2).

## Patentansprüche

1. Verfahren zur Regelung einer Leistung einer elektrischen Last (1), die von einer Wechselstromquelle mit der Periode T gespeist wird, wobei die Last in Reihe mit einem Leistungsdimmer (2) geschaltet ist, der für jede Halbperiode T/2 des Wechselstroms eine Anzahl N von Stromimpulsen erzeugt, die dazu bestimmt sind, die Last zu versorgen, wobei das Verfahren die Anpassung der Anzahl N in Abhängigkeit von der an die elektrische Last (1) abzugebenden Leistung umfasst.

2. Verfahren nach Anspruch 1, wobei, sobald die an die elektrische Last (1) zu liefernde Leistung null ist, die Anzahl N der Stromimpulse für jede Halbperiode T/2 des Wechselstroms ebenfalls null ist.

3. Verfahren nach Anspruch 1 oder 2, wobei die Dauer jedes Stromimpulses weniger als 5 Tausendstel der Periode T beträgt, vorteilhafterweise zwischen 25 Zehntausendstel und 5 Tausendstel der Periode T.

4. Verfahren nach einem der Ansprüche 1 bis 3, wobei die N Stromimpulse für jede Halbperiode T/2 eine im Wesentlichen gleiche Dauer aufweisen.

5. Verfahren nach einem der Ansprüche 1 bis 4, wobei für jede Halbperiode T/2 die N Impulse in Bezug auf die Halbperiode T/2 zentriert und vorteilhafterweise in gleichem Abstand zueinander entfernt sind.

6. Verfahren nach einem der Ansprüche 1 bis 5, wobei die elektrische Last (1) entweder ein elektrisches Heizsystem, einen Elektromotor oder eine LED- oder Leuchtstofflampe, insbesondere mit einer Leistung von weniger als 10 Watt, umfasst.

7. Verfahren nach einem der Ansprüche 1 bis 6, wobei der Leistungsdimmer (2) Folgendes umfasst:
- einen Impulsgenerator (GI) mit zwei Primärklemmen, die als erste Primärklemme (BP1) und zweite Primärklemme (BP2) bezeichnet werden und die die Klemmen des Leistungsdimmers (2) bilden, und mit zwei Sekundärklemmen, die als erste Sekundärklemme (BS1) und zweite Sekundärklemme (BS2) bezeichnet werden;
- einen ersten Darlington-Transistor (TD1) von dem Typ NPN, der über seine Basis mit der ersten Sekundärklemme (BS1) und über seinen Sender mit der ersten Primärklemme (BP1) verbunden ist;
- einen zweiten Darlington-Transistor (TD2) von dem Typ PNP, der über seine Basis mit der zweiten Sekundärklemme (BS2) und über seinen Sender mit der ersten Primärklemme (BP1) verbunden ist.

8. Leistungsdimmer (2), der, wenn er in Reihe zwischen einer elektrischen Last (1) und einer Wechselstromquelle mit der Periode T geschaltet ist, dazu bestimmt ist, für jede Halbperiode des Stroms T/2 des Wechselstroms eine Anzahl N von Stromimpulsen zu erzeugen, die dazu bestimmt ist, die Last zu versorgen, wobei der Dimmer Folgendes umfasst:
- einen Impulsgenerator (Gl) mit zwei Primärklemmen, die jeweils als erste Primärklemme (BP1) und zweite Primärklemme (BP2) bezeichnet werden und die Klemmen des Leistungsdimmers (2) bilden, und mit zwei Sekundärklemmen, die jeweils als erste Sekundärklemme (BS1) und zweite Sekundärklemme (BS2) bezeichnet werden, wobei der Generator (GI) zwischen der ersten Primärklemme (BP1) und der zweiten Primärklemme (BP2), und in dieser Reihenfolge, einen ersten Kondensator (C1) und ein Potentiometer (R1) umfasst, der Generator (GI) auch einen DIAC (DI1) für die Zündspannung Va umfasst, der gemäß einem seiner Anschlüsse, der als Steueranschluss (BD1) bezeichnet wird, mit einem ersten Knoten (N1) verbunden ist, der dem ersten Kondensator (C1) und dem Potentiometer (R1) gemeinsam ist und es ermöglicht, die Zahl N einzustellen, wobei ein zweiter Kondensator (C2) und ein dritter Kondensator (C3) zwischen dem anderen Anschluss des DIAC DI1, dem Ausgangsanschluss (BD2) und dem ersten sekundären Anschluss (BS1) beziehungsweise dem zweiten sekundären Anschluss (BS2) eingefügt sind;
- einen ersten Darlington-Transistor (TD1) von dem Typ NPN, der über seine Basis mit der ersten Sekundärklemme (BS1) und über seinen Sender mit der ersten Primärklemme (BP1) verbunden ist;
- einen zweiten Darlington-Transistor (TD2) von dem Typ PNP, der über seine Basis mit der zweiten Sekundärklemme (BS2) und über seinen Sender mit der ersten Primärklemme (BP1) verbunden ist.

9. Dimmer nach Anspruch 8, wobei der Generator (GI) mit einem zweiten Widerstand (R2) und einem dritten Widerstand (R3) versehen ist, der jeweils die erste Primärklemme (BP1) mit der Ausgangsklemme (BD2) verbindet.

10. Dimmer nach Anspruch 8 oder 9, wobei der Generator (GI) eine erste Diode (D1) und eine zweite Diode (D2) umfasst, die zwischen der ersten Primärklemme (BP1) und der ersten Sekundärklemme (BS1) beziehungsweise der zweiten Sekundärklemme (BS2) angeordnet sind.

11. Dimmer nach einem der Ansprüche 8 bis 10, wobei der Leistungsdimmer (2) eine Schalthilfestufe (RE1) umfasst, die über eine erste Eingangsklemme (BE'1) mit dem Kollektor des ersten Darlington-Transistors (TD1) und über eine zweite Eingangsklemme (BE'2) mit dem Kollektor des zweiten Darlington-Transistors (TD2) verbunden ist, wobei die Schalthilfestufe (RE1) auch zwei Ausgangsklemmen, die jeweils als erste Ausgangsklemme (BS'1) und als zweite Ausgangsklemme (BS'2) bezeichnet werden, umfasst, von denen beide an die zweite Primärklemme (BP'2) angeschlossen sind.

12. Dimmer nach Anspruch 11, wobei die Schalthilfestufe (RE1) einerseits zwischen ihrer ersten Eingangsklemme (BE'1) und ihrer ersten Ausgangsklemme (BS'1) eine dritte und eine vierte Diode (D3) und (D4), die nach entgegengesetzten Polaritäten in Reihe geschaltet sind, und andererseits zwischen ihrer zweiten Eingangsklemme (BE'2) und ihrer zweiten Ausgangsklemme (BS'2) eine fünfte und eine sechste Diode (D5) und (D6), die ebenfalls nach entgegengesetzten Polaritäten in Reihe geschaltet sind, umfasst.

13. Dimmer nach Anspruch 12, wobei die gemeinsame Klemme der dritten und vierten Diode (D3) und (D4) mit der ersten Ausgangsklemme (BS'1) durch einen ersten Zweig verbunden ist, der in Reihe eine erste Induktivität (L1') und einen vierten Widerstand (R4) umfasst, und die gemeinsame Klemme der fünften und sechsten Diode (D5) und (D6) mit der zweiten Ausgangsklemme (BS'2) durch einen zweiten Zweig verbunden ist, der in Reihe eine zweite Induktivität (L2') und einen fünften Widerstand (R5) umfasst.

14. Dimmer nach Anspruch 12, wobei die gemeinsamen Klemmen der dritten und vierten Diode (D3) und (D4) einerseits und der fünften und sechsten Diode (D5) und (D6) andererseits durch eine Induktivität (L1) verbunden sind.

15. Dimmer nach einem der Ansprüche 8 bis 14, wobei das Verfahren die Umsetzung eines Filters (CEM) umfasst, der zwei Eingangsklemmen (X1) und (X2) umfasst, die jeweils mit der ersten Primärklemme (BP1) und der zweiten Primärklemme (BP2) verbunden sind, und zwei Ausgangsklemmen (Y1) und (Y2), die in Reihe mit der elektrischen Last (1) verbunden sind.

16. Dimmer nach Anspruch 15, wobei der Filter (CEM) mit zwei Induktivitäten (L3) und (L4) und einer vierten Kapazität (C4) versehen ist, wobei die beiden Induktivitäten (L3) und (L4), jeweils Eingang (X2) an Ausgang (Y2) und Eingang (X1) an Ausgang (Y1), während die vierte Kapazität (C4) die Ausgänge (Y1) und (Y2) verbindet.

## Claims

1. A method for regulating power of an electrical load (1) supplied with an alternating current source of period T, the load being connected in series with a power dimmer (2) generating, for each half period T/2 of the alternating current, a number N of current pulses for supplying said load, the method comprising adjusting the number N as a function of the power to be delivered to the electrical load (1).

2. The method according to claim 1, wherein once the power to be delivered to the electrical load (1) is zero, the number N of current pulses is also zero for each half-period T/2 of the alternating current.

3. The method according to claim 1 or 2, wherein the duration of each current pulse is less than 5 thousandths of the period T, advantageously between 25 ten thousandths and 5 thousandths of the period T.

4. The method according to one of claims 1 to 3, wherein the N current pulses, for each half period T/2, have a substantially equal duration.

5. The method according to one of claims 1 to 4, wherein, for each half period T/2, the N pulses are centred with respect to said half period T/2 and, advantageously equidistant from each other.

6. The method according to one of claims 1 to 5, wherein the electrical load (1) comprises either an electrical heating system, an electric motor, or an LED or fluorescent bulb, especially with a power of less than 10 Watt.

7. The method according to one of claims 1 to 6, wherein the power dimmer (2) comprises:
- a pulse generator (GI) provided with two primary terminals, respectively called the first primary terminal (BP1) and the second primary terminal (BP2) forming the terminals of the power dimmer (2), and two secondary terminals, respectively called the first secondary terminal (BS1) and the second secondary terminal (BS2);
- a first Darlington transistor (TD1) of the NPN type, connected to the first secondary terminal (BS1) by its base and to the first primary terminal (BP1) by its emitter;
- a second Darlington transistor (TD2) of the PNP type, connected to the second secondary terminal (BS2) by its base and to the first primary terminal (BP1) by its emitter.

8. A power dimmer (2) which, when connected in series between an electrical load (1) and an alternating current source of period T, is, for each half current period T/2 of the alternating current, to generate a number N of current pulses for supplying said load, the dimmer comprising:
- a pulse generator (GI) provided with two primary terminals, respectively called the first primary terminal (BP1) and the second primary terminal (BP2) forming the terminals of the power dimmer (2), and two secondary terminals, respectively called the first secondary terminal (BS1) and the second secondary terminal (BS2), said generator (GI) comprising between the first primary terminal (BP1) and the second primary terminal (BP2), and in order, a first capacitor (C1) and a potentiometer (R1), the generator (GI) also comprises a DIAC (DI1) of an initiation voltage Va connected at one of its terminals, so-called control terminal (BD1), to a first node (N1) common to the first capacitor (C1) and to the potentiometer (R1) for adjusting the number N, a second capacitor (C2) and a third capacitor (C3) are interposed between the other terminal of the DIAC DI1, called the output terminal (BD2), and, respectively, the first secondary terminal (BS1) and the second secondary terminal (BS2);
- a first Darlington transistor (TD1) of the NPN type, connected to the first secondary terminal (BS1) by its base and to the first primary terminal (BP1) by its emitter;
- a second Darlington transistor (TD2) of the PNP type, connected to the second secondary terminal (BS2) by its base and to the first primary terminal (BP1) by its emitter.

9. The dimmer according to claim 8, wherein the generator (GI) is provided with a second resistor (R2) and a third resistor (R3) each connecting the first primary terminal (BP1) to the output terminal (BD2).

10. The dimmer according to claim 8 or 9, wherein the generator (GI) comprises a first diode (D1) and a second diode (D2) interposed between the first primary terminal (BP1) and, respectively, the first secondary terminal (BS1) and the second secondary terminal (BS2).

11. The dimmer according to one of claims 8 to 10, wherein the power dimmer (2) comprises a switching aid stage (RE1) connected to the collector of the first Darlington transistor (TD1) by a first input terminal (BE'1) and to the collector of the second Darlington transistor (TD2) by a second input terminal (BE'2), the switching aid stage (RE1) also comprises two output terminals, respectively called the first output terminal (BS'1) and the second output terminal (BS'2) both connected to the second primary terminal (BP'2).

12. The dimmer according to claim 11, wherein the switching aid stage (RE1) comprises, on the one hand, between its first input terminal (BE'1) and its first output terminal (BS'1), a third and a fourth diodes (D3) and (D4) connected in series with opposite polarities and, on the other hand, between its second input terminal (BE'2) and its second output terminal (BS'2), a fifth and a sixth diodes (D5) and (D6) also connected in series with opposite polarities.

13. The dimmer according to claim 12, wherein the common terminal of the third and fourth diodes (D3) and (D4) is connected to the first output terminal (BS'1) by a first branch comprising, in series, a first inductor (L1') and a fourth resistor (R4), and the common terminal of the fifth and sixth diodes (D5) and (D6) is connected to the second output terminal (BS'2) by a second branch comprising, in series, a second inductor (L2') and a fifth resistor (R5).

14. The dimmer according to claim 12, wherein the common terminals of the third and fourth diodes (D3) and (D4) on the one hand, and of the fifth and sixth diodes (D5) and (D6) on the other hand are connected by an inductor (L1).

15. The dimmer according to one of claims 8 to 14, wherein the method comprises implementing a filter (EMC) which comprises two input terminals (X1) and (X2) connected, respectively, to the first primary terminal (BP1) and to the second primary terminal (BP2), and two output terminals (Y1) and (Y2) connected in series with the electrical load (1).

16. The dimmer according to claim 15, wherein the filter (EMC) is provided with two inductors (L3) and (L4) and a fourth capacitor (C4), the two inductors (L3) and (L4), connecting, respectively, the input (X2) to the output (Y2), and the input (X1) to the output (Y1), while the fourth capacitor (C4) connects the outputs (Y1) and (Y2).
